# EUROPÄISCHE PATENTSCHRIFT

(11) **EP 0 417 641 B1**
(45) Veröffentlichungstag und Bekanntmachung des Hinweises auf die Patenterteilung: **19.03.1997**
(21) Anmeldenummer: 90117159.5
(22) Anmeldetag: 06.09.1990
(51) Int. Cl.: H01J 37/248

(54) **Elektronenstrahlerzeuger und Hochspannungskabel, insbesondere für eine Elektronenstrahlkanone**
Electron beam generator and high voltage cable, particularly for an electron gun
Dispositif de production d'un faisceau d'électrons et câble à haute tension, en particulier pour canon à électrons

(30) Priorität: 09.09.1989 DE 3930200
(43) Veröffentlichungstag der Anmeldung: 20.03.1991
(73) Patentinhaber: PTR PRÄZISIONSTECHNIK GMBH, 63461 Maintal (DE)
(72) Erfinder: Fritz, Dieter, D-6460 Gelnhausen (DE); Schwarz, Wolfgang, Dr., D-6464 Linsengericht (DE)
(74) Vertreter: Sartorius, Peter, Dipl.-Ing.

(56) Entgegenhaltungen:
- FR-A- 2 389 992

## Beschreibung

Die Erfindung betrifft einen Elektronenstrahlerzeuger, insbesondere für eine Elektronenstrahlkanone, mit einer Glühkatode und einer Steuerelektrode, die an einem Hochspannungsisolator angeschlossen und über ein einpoliges Hochspannungskabel an einen Hochspannungserzeuger angeschlossen sind.

Bei einem Elektronenstrahlerzeuger (FR A 2 389 992) ist bereits eine Drosselanordnung für mehrpolige Kabel allgemein bekannt. Die dort aufgezeigte Lösung ist jedoch relativ aufwendig.

Ein weiterer Elektronenstrahlerzeuger dieser Art ist aus der DE-OS 33 33 686 für eine Elektronenstrahlkanone zum Erwärmen von Materialien, insbesondere zum Schweißen, bekannt. Bei dieser bekannten Elektronenstrahlkanone ist durch die konstruktive Vereinigung des Strahlkopfes mit einer vollständigen Hilfsspannungsübertragung ein mehrpoliges Hochspannungskabel mit den dazugehörigen, mehrpoligen Steckverbindungen nicht mehr erforderlich, so daß vor allem die Ohmschen Leitungsverluste durch den Heizstrom nahezu zu Null werden. Durch den Wegfall dieser Verluste ist die zu übertragende Leistung erheblich reduziert und das Volumen der Isoliertransformatoren wird nicht mehr durch die zu übertragende Leistung sondern nur noch durch die notwendigen Isolationsabstände bestimmt. Die Einspeisung der Isoliertransformatoren liegt dabei auf Erdpotential und die Zufuhr der Steuerspannungen erfolgt über Mehrfachstecker auf dem Niederspannungspotential des Strahlkopfes.

Durch die sehr viel bessere kapazitive Kopplung zwischen den einzelnen Potentialen bei der bekannten Elektronenstrahlkanone sind durch Überschläge und damit verbundene Überspannungen verursachte Ausfälle von Bauteilen der Hilfsspannungserzeugung bereits wesentlich herabgesetzt. Es besteht noch immer das Bedürfnis, die Betriebssicherheit der übrigen elektronischen Ausrüstung derartiger Elektronenstrahlanlagen zu erhöhen.

Es ist daher Aufgabe der Erfindung, bei einem Elektronenstrahlerzeuger der eingangs genannten Art die Betriebssicherheit zu erhöhen und Ausfälle von Bauteilen durch Überspannungen in der elektronischen Ausrüstung der Anlage und des Hochspannungserzeugers zu reduzieren.

Die Aufgabe wird erfindungsgemäß dadurch gelöst, daß ein Elektronenstrahlerzeuger, insbesondere für eine Elektronenstrahlkanone, mit einer Glühkatode und einer Steuerelektrode, die an einem Hochspannungsisolator angeschlossen und über ein einpoliges Hochspannungskabel an einen Hochspannungserzeuger angeschlossen sind, wobei auf dem Hochspannungsisolator ein Isoliertransformator zur Umwandlung des Katodenheizstroms angeordnet ist, dessen Primärwicklung auf Erdpotential liegt und der als Stromwandler für den Kathodenstrom dient, wobei zur Vermeidung von Reflexionen und Wanderwellen das Hochspannungskabel an beiden Enden mit einem Schutzwiderstand abgeschlossen ist, dessen Wellenwiderstand dem Wellenwiderstand des Hochspannungskabels entspricht bzw. angepaßt ist.

Durch die erfindungsgemäße Anordnung von Schutzwiderständen werden bei Hochspannungsüberschlägen im Elektronenstrahlerzeuger Reflexionen und Wanderwellen verhindert und damit Rückwirkungen auf den Hochspannungsgenerator erheblich reduziert. Dies hat zur Folge, daß Isolations- und Bauteilschäden im Hochspannungserzeuger und in der gesamten elektrischen Ausrüstung der Elektronenstrahlanlage erheblich vermindert werden und die Betriebssicherheit der Anlage wesentlich verbessert wird. Die Erfindung ermöglicht weiterhin den Einsatz langer Hochspannungskabel ohne Nachteil für die Betriebssicherheit der Anlage.

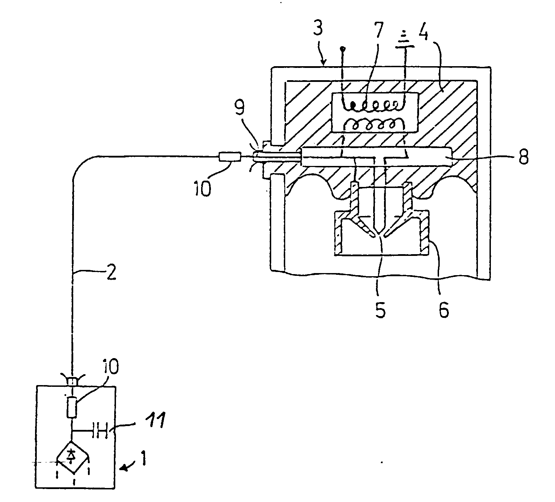

Anhand der in der Zeichnung dargestellten Schaltskizze wird die erfindungsgemäße Anordnung des Schutzwiderstands näher erläutert. Die Zeichnung zeigt den Hochspannungsgenerator 1 der über ein einpoliges Hochspannungskabel 2 mit dem Strahlkopf 3 eines Elektronenstrahlerzeugers verbunden ist. Der Strahlkopf 3 enthält einen Hochspannungsisolator 4, der eine Katode 5 und eine Steuerelektrode 6 trägt. Im Hochspannungsisolator 4 befindet sich ein Isoliertransformator 7, dessen Primärwicklung auf Erdpotential liegt und der als Stromwandler für den Katodenstrom dient. Weiterhin sind im Hochspannungsisolator 4 in einer Kapsel 8 Schaltungselemente zur Steuerung des Elektronenstrahlerzeugers angeordnet, die über einen Hochspannungsanschluß 9 mit dem Hochspannkabel 2 verbunden sind. Das am Hochspannungserzeuger angeschlossene Ende und das mit dem Strahlkopf 3 verbundene Anschlußende des Hochspannungskabels 2 sind jeweils durch einen ersten und zweiten Schutzwiderstand 10, 10 abgeschlossen, wobei die Impedanz des Wellenwiderstandes 10 dem Wellenwiderstand des Hochspannungskabels 2 entspricht.

## Patentansprüche

1. Elektronenstrahlerzeuger, insbesondere für eine Elektronenstrahlkanone, mit einer Glühkatode und einer Steuerelektrode (6), die an einem Hochspannungsisolator (4) angeschlossen und über ein einpoliges Hochspannungskabel (2) an einen Hochspannungserzeuger (1) angeschlossen sind, wobei auf dem Hochspannungsisolator (4) ein Isoliertransformator zur Umwandlung des Katodenheizstroms angeordnet ist, dessen Primärwicklung (7) auf Erdpotential liegt und der als Stromwandler für den Kathodenstrom dient, wobei zur Vermeidung von Reflexionen und Wanderwellen das Hochspannungskabel (2) an beiden Enden mit einem Schutzwiderstand (10, 10 ) abgeschlossen ist, dessen Wellenwiderstand dem Wellenwiderstand des Hochspannungskabels (2) entspricht bzw. angepaßt ist.

## Claims

1. Electron beam generator, especially for an electron gun, with a hot cathode and a control electrode (6) which are connected to a high-voltage insulator (4) and to a high-voltage generator (1) via a single-pole high-voltage cable (2), whereby there is an insulating transformer arranged on the high-voltage insulator (4) for converting the cathode heating current whose primary winding (7) is at ground potential and which serves as a current transformer for the cathode current, whereby, in order to avoid reflections and traveling surges, both terminal ends of the high-voltage cable (2) are closed off with protective resistors (10, 10 ) whose impedance corresponds to or matches the wave impedance of the high-voltage cable (2).

## Revendications

1. Générateur de faisceau électronique, destiné notamment à un canon à électrons et comportant une cathode à incandescence et une électrode de commande (6) connectées à un isolateur haute tension (4) et branchées sur une génératrice haute tension (1) par l'intermédiaire d'un câble haute tension unipolaire (2), et dans lequel un transformateur d'isolement pour la transformation du courant cathodique de chauffage dont l'enroulement primaire se trouve au potentiel de la terre est disposé sur l'isolateur haute tension (4) et sert de transformateur d'intensité du courant cathodique, le câble haute tension (2), afin d'éviter des réflexions et des ondes progressives, se terminant aux deux extrémités par une résistance protectrice (10, 10) dont l'impédance caractéristique correspond à l'impédance caractéristique du câble haute tension (2) ou est adaptée à celle-ci.
